# EUROPÄISCHE PATENTSCHRIFT

(11) **EP 1 407 544 B1**
(45) Veröffentlichungstag und Bekanntmachung des Hinweises auf die Patenterteilung: **26.09.2007**
(21) Anmeldenummer: 02787125.0
(22) Anmeldetag: 10.07.2002
(51) Int. Cl.: H03G 5/00, H03G 5/12

(54) **FILTERSCHALTUNG UND VERFAHREN ZUR VERARBEITUNG EINES AUDIOSIGNALS**
FILTER CIRCUIT AND METHOD FOR PROCESSING AN AUDIO SIGNAL
CIRCUIT FILTRE ET PROCEDE DE TRAITEMENT D'UN SIGNAL AUDIO

(30) Priorität: 18.07.2001 DE 10134927
(43) Veröffentlichungstag der Anmeldung: 14.04.2004
(73) Patentinhaber: SPL Electronics Gmbh, 41372 Niederkrüchten (DE)
(72) Erfinder: NEUMANN, Wolfgang, 41372 Niederkrüchten (DE); GIER, Hermann, 41372 Niederkrüchten (DE)
(74) Vertreter: Liesegang, Eva
(86) Internationale Anmeldenummer: PCT/EP2002/007703
(87) Internationale Veröffentlichungsnummer: WO 2003/009469

(56) Entgegenhaltungen:
- US-A- 4 422 048
- US-A- 4 432 097
- US-A- 4 709 391
- US-A- 5 046 105

## Beschreibung

Die Erfindung betrifft eine Filterschaltung und ein Verfahren zur Verarbeitung eines Audiosignals, die dazu geeignet sind, Audiosignale über der gesamten üblichen Übertragungsbandbreite, etwa 10 Hz bis 50 kHz, derart zu bearbeiten, daß ein verbesserter, angenehmerer Klang entsteht. Solche Filterschaltungen sind auch als Equalizer bekannt und werden als analoge Schaltungen beispielsweise in Tonmischpults für die Verstärkung und/oder Aufnahme von Musik sowie in Geräten der Konsumerelectronik, Informationstechnologie und Telekommunikation eingesetzt.

Das US-Patent 4,709,391 beschreibt eine Filterschaltung zur Verarbeitung eines Audiosignals zur Minderung der Verzerrung des Ausgangssignals. Die Schaltung umfaßt ein nicht-lineares Netzwerk mit wenigstens zwei parallelen Zweigen, wobei wenigstens einer dieser Zweige nicht-lineare Verzerrung zweiter oder höherer Ordnung kompensiert.

Die heute bekannten Filter sind in der Regel auf einen ausgewählten Frequenzbereich der Audio-Übertragungsbandbreite skaliert. Durch eine Kaskadenschaltung mehrerer solcher Filter wird ein Equalizer, oder Entzerrer, gebildet, der das gesamte Audio-Frequenzspektrum abdeckt und ein Audiosignal derart verarbeitet, daß ein gewünschter Klangeffekt und insbesondere eine angenehme Klangwirkung entsteht. Jeder einzelne Filter kann Regler oder Einstellmöglichkeiten für die Bandbreite, die Frequenz, die Verstärkung oder Unterdrückung (Boost/Cut) und dergleichen enthalten, wobei diese Regler oder Einstellmöglichkeiten jeweils auf die entsprechenden Parameter des zugehörigen Filters wirken. Die Filter des Equalizers sind von einander unabhängig, d.h. die Einstellung eines Filters beeinflußt nicht die Einstellung eines anderen Filters.

Verschiedene Filtertypen und Möglichkeiten zu deren Realisierung sind bekannt. Grundsätzlich ist die Funktion eines Filters, bestimmte Frequenzkomponenten oder -bereiche eines Signals zu dämpfen oder bevorzugt zu übertragen. Filter werden unterschieden nach Art des im

Filter verarbeiteten Signals, als analoge Filter oder digitale Filter, bezüglich der schaltungstechnischen Realisierung, als Reaktanzfilter, aktive Filter oder monolithische Filter, bezüglich des Frequenzbereichs und des Frequenzintervalls, z.B. als Tiefpaßfilter, Hochpaßfilter, Bandpaßfilter, Allpaßfilter und Bandsperre, und bezüglich der Übertragungsfunktion und Impulsantwort, als rekursive Filter oder nicht rekursive Filter, insbesondere Tranversalfilter oder FIR-Filter. Die Grundlagen der Filtertechnik sind z.B. beschrieben in Prof. Manfred Seifert: Analoge Schaltungen, Verlag Technik GmbH, 1994. Weiterer Hintergrund zum Entwurf von Filterschaltungen findet sich z.B. in Arthur B. Williams, Fred J. Taylor: Electronic Filter Design Handbook, Mc Graw-Hill Book Company, 1988; E. Zwicker, M. Zollner: Elektroakustik, Springer Verlag, 1987; U. Titzer, Ch. Schenk: Halbleiter-Schaltungstechnik, Springer Verlag, 1999.

Filterschaltung zur Verarbeitung analoger oder digitaler Signale werden im Stand der Technik überall dort eingesetzt, wo Lautsprecher für die Wiedergabe von Ton, wie Sprache oder Musik, verwendet werden. Der Filterschaltung ist in der Regel eine Endstufe, Verstärker, und ein Schallwandler, Lautsprecher, nachgeschaltet. Übliche Einsatzarten der Filterschaltungen des Standes der Technik und der Filterschaltung gemäß der Erfindung sind in der Consumer Electronic, wie in Radios, Radioempfängern, Satellitenempfängern, Fernsehempfängern, Playstation und dergleichen, in der IT-Technik, wie in Soundkarten für Computern, und in der Telekommunikationstechnik, wie in Mobiltelefonen und Telefonendgeräten. Die Filterschaltung kann jedoch auch in Ton-Mischpulten und ähnlichem eingesetzt werden.

Der Erfindung liegt die Aufgabe zu Grunde, eine neue Filterschaltung und ein Verfahren zur Verarbeitung eines Audiosignals anzugeben, welche Eingangssignale im gesamten für die Übertragung von Audiosignalen üblichen Frequenzbereich, von etwa 10 Hz bis 50 kHz verarbeiten können und die eingehenden Audiosignale derart verarbeiten und entzerren, daß ein angenehmer Höreindruck entsteht.

Diese Aufgabe wird durch eine Filterschaltung mit den Merkmalen von Anspruch 1 sowie durch ein Verfahren mit den Merkmalen von Anspruch 11 gelöst.

Die Erfindung sieht eine Filterschaltung und ein Verfahren zur Verarbeitung eines Audiosignals vor, die aus mehreren, miteinander verknüpften Einzelfiltern aufgebaut sind. Eine Anzahl verschiedener Filterstufen sind in Reihe geschaltet, und das Audiosignal wird in die erste Filterstufe der in Reihe geschalteten Filterstufen eingegeben und über die Reihenschaltung zu einem Ausgang der Filterschaltung geführt. Gleichzeitig wird das Audiosignal direkt, also unter Umgehung der ersten, zweiten etc. Filterstufe in die weiteren Filterstufen als zusätzliches Eingangssignal eingegeben sowie im wesentlichen unverarbeitet zu dem Ausgang geführt. Am Ausgang werden das im wesentlichen unverarbeitete Audiosignal sowie das Ausgangssignal der in Reihe geschalteten Filterstufen summiert. Die einzelnen Filterstufen sind derart miteinander verknüpft, daß sie sich gegenseitig beeinflussen, so daß eine Veränderung einer Filterstufe auch das Verhalten der nachfolgenden Filterstufen beeinflußt. Durch die erfindungsgemäße Verknüpfung der einzelnen Filterstufen kann über die Einstellung einzelner Parameter ausgewählter Filterstufen eine interaktive Wechselwirkung zwischen den Filterstufen erreicht werden, durch die das Audiosignal auf gewünschte Weise beeinflußt werden kann, um einen gewünschten Höreindruck zu erzeugen. Bei der anschließenden Verknüpfung des verarbeiteten Audiosignals mit dem im wesentlichen unverarbeiteten Audiosignal in einer Summierstufe ergibt sich eine einstellbare Entzerrungskurve, mit der bestimmte Frequenzbereiche betont bzw. angehoben und gleichzeitig andere Frequenzbereiche in einem gewünschten Verhältnis dazu abgesenkt werden. Durch das Zusammenwirken der einzelnen Filterstufen kann neben der reinen Frequenz-Amplitudenbearbeitung auch eine Phasenverschiebung des Audiosignals in Abhängigkeit von der Amplitude erzeugt werden. Die erfindungsgemäße Filterschaltung arbeitet vorzugsweise in einem Frequenzbereich von 10 Hz bis 50 kHz, insbesondere 20 Hz bis 22 kHz.

Überraschenderweise hat sich gezeigt, daß die erfindungsgemäße Verknüpfung der Filterstufen und insbesondere die Wechselwirkung der Filterstufen unter einander zu einer vorteilhaften Entzerrung und einem angenehmen Höreindruck führen, wenn das Ausgangssignal über einen elektroakustischen Wandler geführt wird. Der angenehmere Höreindruck wird bei der Filterschaltung gemäß der Erfindung insbesondere durch eine verbesserte Tiefenstaffelung des Klangs, eine erhöhte Trennung der Instrumentierung, eine Verbesserung von Klarheit und Transparenz der Töne sowie eine subjektive Lautheitserhöhung erreicht.

Die erfindungsgemäße Filterschaltung kann durch einen analogen Schaltkreis ebenso realisiert werden wie durch einen programmierten digitalen Algorithmus. Das Filter kann somit in Software, Firmware oder Hardware realisiert sein.

Grundsätzlich wird bei der Erfindung das Audio-Eingangssignal in zwei Wege aufgeteilt: über den ersten Weg oder Zweig wird das Audiosignal als ein Bezugsignal im wesentlichen unverarbeitet, im Verhältnis 1:1, einem nicht-invertierenden Eingang einer Ausgangs-Summierstufe zugeführt. Der zweite Weg oder Zweig wird vorzugsweise über eine regelbare Verstärkerstufe geführt, deren Ausgangssignal als Haupt-Amplitudensteuerung für alle nachfolgenden Filterstufen dient. Dieses Ausgangssignal der regelbaren Verstärkerstufe wird mehreren Nebenzweigen zugeführt, wobei die Nebenzweige an ihren Eingängen jeweils Widerstände aufweisen, welche das Audiosignal gewichten und auf die verschiedenen Filterstufen verteilen.

Optional kann der erste Zweig eine Schaltfunktion oder einen Schalter zum Abschalten des Bezugssignals zur Summierstufe aufweisen. Dies hat zur Folge, daß nur das im zweiten Zweig geführte Audiosignal am Ausgang der Filterschaltung anliegt. Dieses Signal kann dann an anderer Stelle, z.B. in einem Ton-Mischpult über Hilfswege, seinem ursprünglichen Audiosignal bzw. dem Bezugssignal zugemischt werden.

Die in dem zweiten Zweig in Reihe geschalteten Filterstufen umfassen vorzugsweise ein Steuerfilter, ein modifiziertes Bandpaßfilter und ein modifiziertes Universalfilter, die in dieser Reihenfolge in Reihe geschaltet sind. Das Steuerfilter ist als ein aktiver Flächeneinsteller realisiert. Ein Flächeneinsteller ist im Prinzip ein Filter, das Bässe und Höhen regelt, wobei die Frequenzen für die Bässe und Höhen fest voreingestellt sind und die Amplituden für Bässe und Höhen regelbar sind. Erfindungsgemäß ist das Steuerfilter so realisiert, daß es für einen höheren Frequenzbereich in Frequenz und Amplitude fest eingestellt ist, und für einen tieferen Frequenzbereich eine feste Frequenz und eine variable Amplitude aufweist, wobei die variable Amplitude über einen Regler eingestellt werden kann.

Das Ausgangssignal des Steuerfilters wird dem modifizierten Bandpaßfilter zugeführt, wobei das Bandpaßfilter als weiteres Eingangssignal das im wesentlichen unverarbeitete Audiosignal über einen weiteren, gewichteten Nebenzweig empfängt. Dieses modifizierte Bandpaßfilter betont den tiefen Frequenzbereich des Audiosignals und wirkt wie ein frequenzabhängiger Widerstand gegen Masse, der bei einer gewünschten Frequenz, z.B. 50 Hz, sein Maximum erreicht.

Das Ausgangssignal der Reihenschaltung aus dem Steuerfilter und dem modifizierten Bandpaßfilter wird einem Steuereingang des modifizierten Universalfilters zugeführt. Durch in dem Steuerfilter vorhandene Regler und die Summierung der Funktionen von Steuerfilter und modifiziertem Bandpaßfilter wird am Eingang des modifizierten Universalfilters eine Frequenz- und Phasenregulierung des Baßbereichs bewirkt. Die Wirkung dieser beiden Filter zusammen ist somit in Kombination anders, als wenn jeweils nur einer der Filter vorhanden wäre oder die Filter voneinander entkoppelt wären.

Die Einstellung des modifizierten Universalfilters erfolgt über zwei Signalwege: das Summenausgangssignal aus dem Steuerfilter und dem Bandpaßfilter steuert über einen Spannungsteiler den nicht-invertierenden Eingang einer ersten Integratorstufe an, welche als Tiefpaß arbeitet. Dem Tiefpaß sind ein Bandpaß und ein Hochpaß nachgeschaltet, wobei Tiefpaß, Bandpaß und Hochpaß insgesamt so kombiniert sind, daß sie eine erste und eine zweite Integratorstufe umfassen, die weiter unten noch näher ausgeführt ist.

Der zweite Ansteuerweg erfolgt über einen weiteren Nebenzweig mit dem im wesentlichen unverarbeiteten Audiosignal über den nicht-invertierenden Eingang einer Verstärkerstufe. Der Ausgang dieser Verstärkerstufe ist über einen Knoten mit dem nicht-invertierenden Eingang der Hochpaßstufe des modifizierten Universalfilters verbunden, an dem ferner ein Regler angeschlossen ist. Dieser Knoten führt über einen weiteren Regler zum Ausgang des Universalfilters, der auf einen invertierenden Eingang der Ausgangs-Summierstufe gelegt ist.

Mit dem zuerst genannten Regler läßt sich die Bandbreite des Universalfilters einstellen, welche den Frequenzbereich für die Mitten-Hochton-Absenkung bzw. -Anhebung bestimmt. Über den zweiten Regler kann das Ausgangssignal des Universalfilters auf die Summierstufe aufgeregelt werden. Dieser Regler kann auch als Prozeß-Regler bezeichnet werden.

Erfindungsgemäß kann in einem weiteren Nebenzweig ein Hoch- und Obertonfilter vorgesehen sein, der das im wesentlichen unverarbeitete Audiosignal empfängt und dessen Ausgang mit dem nicht-invertierenden Eingang der Ausgang-Summierstufe verbunden ist.

Durch die erfindungsgemäße Verteilung des Audiosignals auf die Filterstufen und der Filterausgangssignale sowie des Bezugssignals auf die invertierenden und nicht-invertierenden Eingänge der Ausgangs-Summierstufe entsteht eine Wechselwirkung von Frequenz und Phase des Audiosignals am Ausgang des Summierers. Diese Wechselwirkung, zusätzlich erweitert durch Regler und/oder Schalter sowie Einsteller in den einzelnen Filterstufen bestimmt die Frequenzentzerrung, oder Klangfilterkurven, der erfindungsgemäßen Filterschaltung.

Während im Stand der Technik vergleichbare Filterschaltungen oder Entzerrer mehrere in Reihe oder parallel geschaltete Filterstufen verwendeten, welche sich im wesentlichen nicht gegenseitig beeinflussen sollten, haben die Erfinder ein neuartiges Filter gefunden, bei der die Wechselwirkung zwischen den einzelnen Filterstufen gezielt genutzt wird, um eine gewünschte Entzerrung und Klangverbesserung zu erreichen. Dieses Filter, das als analoge Filterschaltung beschrieben wurde, ist in gleicher Weise auch als digitales Filter in einem Computerprogramm realisierbar.

Die Erfindung ist im folgenden anhand bevorzugter Ausführungsform mit Bezug auf die Zeichnung näher erläutert. In den Figuren zeigen:
Fig. 1 eine schematische Blockdarstellung einer bevorzugten Ausführungsform der erfindungsgemäßen Filterschaltung;
Fig. 2 einen detaillierten Schaltplan der erfindungsgemäßen Filterschaltung; und
Fig. 3 ein Ablaufdiagramm zur Erläuterung der Realisierung des erfindungsgemäßen Verfahrens in einem Computerprogramm.

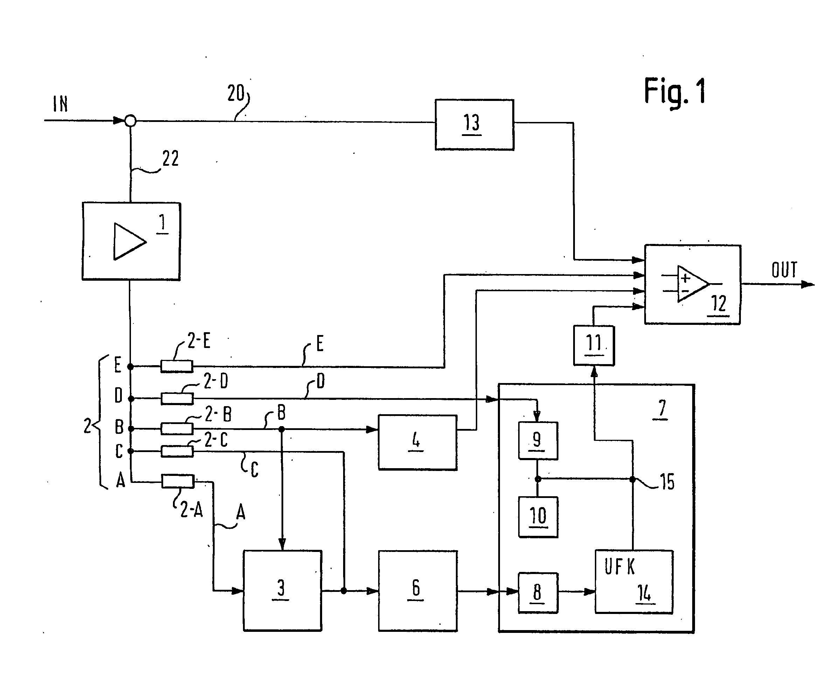

Fig. 1 zeigt eine bevorzugte Ausführungsform der erfindungsgemäßen Filterschaltung als schematisches Blockdiagramm.

In Fig. 1 ist ein Audio-Eingangssignal mit in und ein Audio-Ausgangssignal mit out bezeichnet. Das Audio-Eingangssignal in wird in zwei Zweige 20, 22 aufgeteilt, wobei der erste Zweig 20 als Bezugszweig bezeichnet werden kann und der zweite Zweig 22 als Filterzweig. Der Bezugszweig 20 weist eine 1:1-Treiberstufe 13 auf, welche das Audio-Eingangssignal in unverarbeitet dem nicht-invertierenden Eingang einer Summierstufe 12 zuführt.

Am Eingang des Filterzweiges 22 liegt eine regelbare Verstärkerstufe 1, welche eine Amplitudensteuerung des Audio-Eingangssignals in für die nachfolgenden Filterstufen durchführt, darüber hinaus das Audio-Eingangssignals in jedoch nicht weiter verarbeitet. Das Ausgangssignal der regelbaren Verstärkerstufe 1 wird über mehrere parallel geschaltete Widerstände 2-A, 2-B, 2-C, 2-D, 2-E auf mehrere, bei der gezeigten Ausführung fünf, (5), Nebenzweige aufgeteilt, wobei die Widerstände dazu dienen, das Verhältnis der Nebenzweige einzustellen. Wie durch den "Widerstand" 2-D in Figur 1 angedeutet, müssen die Widerstände nicht notwendig in allen Nebenzweigen vorgesehen sein, solange das gewünschte Verhältnis zwischen den einzelnen Nebenzweigen erreicht wird. Bei einer Softwarerealisierung der Erfindung können die Verstärkerstufe durch eine Multiplikation und die Widerstände durch entsprechende Wichtungsfunktionen verwirklicht werden.

In dem Bezugszweig 20 kann optional (nicht gezeigt) ein Schalter vorgesehen bzw. eine Schaltfunktion realisiert sein, um diesen Zweig zu unterbrechen, so daß das unverarbeitete und unverstärkte Audiosignal nicht zu Summierstufe 12 gelangt. Es liegt dann nur das gefilterte Signal am Ausgang der Filterschaltung an, wobei das Bezugssignal an anderer Stelle, z.B. in einem Audio-Mischpult über Aux send/return-Wege, dem gefilterten Signal aufgemischt werden kann.

Im ersten Nebenzweig A sind ein Steuerfilter 3, ein modifiziertes Bandpaßfilter 6 und ein modifiziertes Universalfilter 7 in dieser Reihenfolge in Reihe geschaltet, wobei das Ausgangssignal des modifizierten Universalfilters 7 dem invertierenden Eingang der Summierstufe 12 zugeführt wird. Der zweite Nebenzweig B enthält ein optionales Hoch- und Obertonfilter 4, dessen Ausgangssignal dem nicht-invertierenden Eingang der Summierstufe 12 zugeführt wird. Das Eingangssignal des Hoch- und Obertonfilters 4 wird auch dem Steuerfilter 3 zugeführt. Der dritte Nebenzweig C führt das im wesentlichen unverarbeitete Audiosignal zusammen mit dem Ausgangssignal des Steuerfilters 3 auf den Eingang des Bandpaßfilters 6. Über den vierten Nebenzweig D wird das im wesentlichen unverarbeitete Audiosignal dem Universalfilter 7 direkt zugeführt. Über den fünften Nebenzweig E wird das amplitudenverstärkte, im übrigen aber unverarbeitete Audiosignal direkt auf einen nicht-invertierenden Eingang der Summierstufe 12 geführt.

Das modifizierte Universalfilter 7 umfaßt grundsätzlich eine erste Eingangsstufe mit einem Spannungsteiler 8, der das Ausgangssignal des modifizierten Bandpaßfilters 6 empfängt und an den Eingang des Universalfilterkerns 14 anlegt. Das modifizierte Universalfilter 7 weist eine zweite Eingangsstufe mit einem Vorverstärker 9 auf, die das im wesentlichen unverarbeitete Audiosignal empfängt und deren Ausgang über einen Ausgangsknoten 15 mit einem Regler 10 und dem Universalfilterkern 14 verbunden ist. Der Knoten 15 ist auch auf einen Ausgangsregler 11 geführt, dessen Ausgang mit dem invertierenden Eingang der Summierstufe 12 verbunden ist. Der Universalfilterkern 14 umfaßt, wie unten noch näher erläutert ist, ein Tiefpaßfilter, ein Bandpaßfilter und ein Hochpaßfilter und deckt das gesamte hörbare Spektrum von 20 Hz bis 22 kHz ab. Insbesondere werden in dem modifizierten Universalfilter über den Regler 10 Frequenzbereiche eingestellt, die angehoben oder angesenkt werden sollen. Zum Beispiel kann der Regler 10 eine Bandbreite von etwa 1 kHz. bis etwa 22 kHz abdecken.

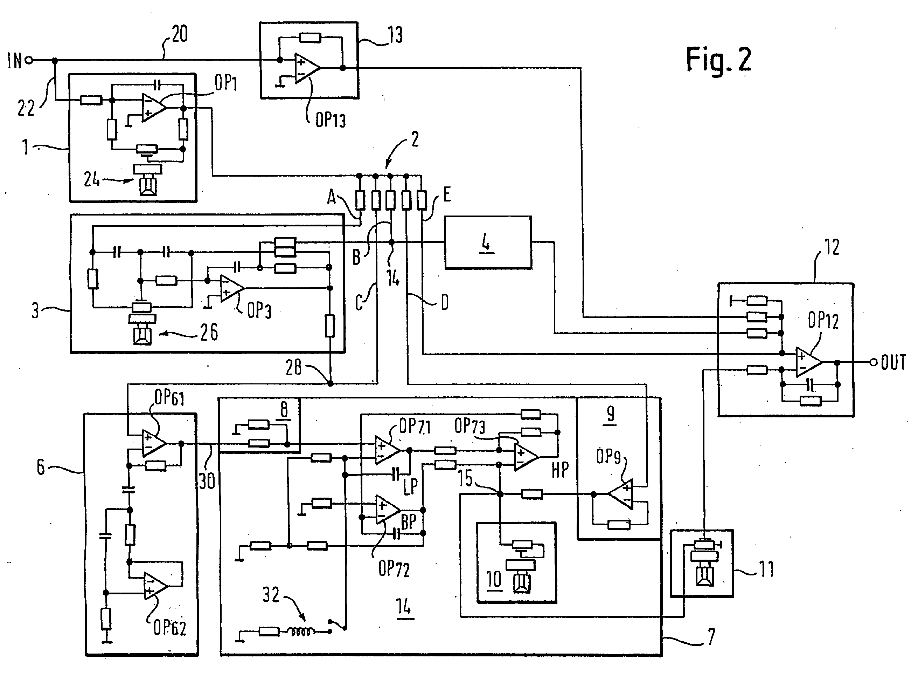

Das Steuerfilter 3 und das modifizierte Bandpaßfilter 6 dienen zur Ansteuerung des Universalfilters 7 und spezieller des Universalfilterkerns 14. Sie sind für einen bestimmten Frequenzbereich festdimensioniert und für einen weiteren Frequenzbereich variabel einstellbar, wie mit Bezug auf Fig. 2 noch näher erläutert ist. Das Bandpaßfilter 6 ist aufgebaut wie ein frequenzabhängiger Widerstand gegen Masse und erzeugt eine Baßfrequenz von etwa 50 Hz, wie ebenfalls mit Bezug auf Fig. 2 näher erläutert ist. Wie bereits erwähnt, ist das Steuerfilter als aktiver Flächeneinsteller realisiert, der für einen höheren Frequenzbereich eine feste Frequenz- und Amplitudeneinstellung aufweist und für einen niedrigeren Frequenzbereich eine feste Frequenzeinstellung und eine variable Amplitudeneinstellung.

Die Summe der Funktionen dieser beiden Filter wird der ersten Eingangsstufe 8 des Universalfilters 7 bzw. Universalfilterkerns 14 zugeführt, wobei über den im Steuerfilter 3 vorhandenen Regler, der auch als Baßsoundregler bezeichnet werden kann, und die Addition mit dem modifizierten Bandpaßfilter eine gewünschte Frequenzentzerrung in dem modifizierten Universalfilter 7 eingestellt werden kann.

Vereinfacht gesagt bewirkt hierbei das Steuerfilter 3 eine Frequenzselektion, das Bandpaßfilter 6 eine Frequenzaddition im Baßbereich und somit eine Phasenverschiebung und der Regler 10 im Universalfilter 7 eine Frequenzregelung.

Zum Beispiel kann in dem modifizierten Universalfilter der Frequenzbereich von etwa 20 bis 150 Hz verstärkt, der Frequenzbereich von etwa 150 bis 500 Hz abgesenkt, und der darüber hinausgehende Frequenzbereich wieder verstärkt werden. Der Regler 10 kann den Bereich der Frequenzabsenkung einstellen, z.B. auf etwa 150 bis 700 Hz (größte Bandbreite, kleinstes Q) oder auf gewünschte andere Werte, die Absenkung kann z.B. ausgedehnt werden auf bis zu 20 kHz, so daß nur die Spitzenwerte über 20 kHz bis etwa 22 kHz verstärkt werden.

Für die weitere Bearbeitung von Hochton-Frequenzen oder zur Erzeugung zusätzlicher Obertöne (Harmonische) kann das Eingangssignal optional dem Hoch- und Obertonfilter 4 zugeführt werden. Das optionale Hoch- und Obertonfilter 4 betont den höheren Frequenzbereich. Als weitere Optionen können in dem Nebenzweig B ein KompressorBegrenzer zur Pegelkontrolle, eine Stufe zur Zeitkorrektur oder dergleichen eingesetzt werden.

Die erste Eingangsstufe des Universalfilters 7 mit dem Spannungsteiler 8 ist ein wichtiger Schaltungspunkt in der erfindungsgemäßen Filterschaltung zur Ansteuerung und Einstellung des Universalfilters. Das Universalfilter kann zusätzlich durch Integration von Reglern und/oder zuschaltbaren Induktivitäten bei diesem Steuereingang weitere Operationen und Schaltungserweiterungen für eine noch weitergehende Klangfilterung vorsehen.

Am Ausgang des Universalfilters 7 können für die weitere Verarbeitung des Audiosignals beispielsweise wiederum ein Kompressor/Begrenzer, ein Zeitkorrekturelement oder dergleichen vorgesehen sein.

Die erfindungsgemäße Filterschaltung ist im folgenden mit Bezug auf Fig. 2 mit weiteren Einzelheiten erläutert.

Fig. 2 zeigt dieselben Grundelemente wie das Blockschaltbild der Fig. 1, welche mit denselben Bezugszeichen bezeichnet sind. Diese umfassen die regelbare Verstärkerstufe 1 am Eingang des Filterzweiges 22, das Widerstandsnetzwerk 2, mit den Widerständen 2-A, 2-B, 2-C, 2-D und 2-E, welche die Gewichtung der Nebenzweige einstellen, das Steuerfilter oder Flächeneinsteller 3, das modifizierte Bandpaßfilter 6, das modifizierte Universalfilter 7, das Hoch- und Obertonfilter 4 und den Regler 11 sowie die Treiberstufe 13 im ersten oder Bezugszweig 20 und die Ausgangs-Summierstufe 12.

Das Audio-Eingangssignal in wird über den Bezugszweig 20 durch die 1:1-Treiberstufe 13, die einen Operationsverstärker OP₁₃ aufweist, und über einen Widerstand dem nicht-invertierenden Eingang eines als Summierer konfigurierten Operationsverstärker OP₁₂ der Ausgangs-Summierstufe 12 zugeführt. In dem Bezugszweig 20 kann optional ein Schalter (nicht gezeigt) zur Unterbrechung des Bezugszweigs 20 vorgesehen sein. Dadurch kommt nur das gefilterte Audiosignal über den Filterzweig 22 zu der Ausgangssummierstufe 12. Das unverarbeitete Audiosignal oder Referenzsignal kann dann an anderer Stelle dem gefilterten Signal zugemischt werden.

Der Filterzweig 22 geht zunächst durch die regelbare Verstärkerstufe 1, welche einen Operationsverstärker OP₁ sowie einen Regler 24 aufweist, welcher die Ansteuerverstärkung für die nachfolgenden Filterstufen bestimmt.

Das Ausgangssignal der regelbaren Verstärkerstufe 1 wird über das Widerstandsnetzwerk 2 auf die verschiedenen Nebenzweige A, B, C, D, E geführt, wobei die Widerstände des Widerstandsnetzwerkes Werte im Bereich von z.B. 1 kΩ bis 100 kΩ haben können. Das Widerstandsnetzwerk 2 teilt den zweiten Zweig oder Filterzweig 22 passiv in fünf Nebenzweige auf, welche über Vorwiderstände getrimmt werden, um deren Verhältnis einzustellen.

Der erste Nebenzweig A führt zu dem Steuerfilter 3, das ein abgewandelter aktiver Flächeneinsteller ist, der für einen bestimmten höheren Frequenzbereich in Amplitude und Frequenz fest dimensioniert und für einen niedrigeren Frequenzbereich in der Frequenz fest eingestellt und in der Amplitude über einen Regler 26 variabel ist. Das Steuerfilter 3 umfaßt den Regler 26 sowie einen Operationsverstärker OP₃, die wie in Fig. 2 gezeigt über Widerstände und Kondensatoren verbunden sind. Der Operationsverstärker OP₃ weist eine Rückkopplung auf, die einen Widerstand und einen Kondensator zwischen dem Ausgang und dem invertierenden Eingang des Operationsverstärkers OP₃ umfaßt, welche in Reihe geschaltet sind. Am Verbindungspunkt zwischen Widerstand und Kondensator liegt ein weiterer Widerstand, der über den Nebenzweig B ein Teil seines Steuersignals erhält. Der Regler 26 ist ebenfalls auf den invertierenden Eingang des Operationsverstärkers OP₃ geschaltet, um die variable Baß-Amplitude einzustellen.

Der Nebenzweig B weist auch einen Abzweigpunkt 14 zur Abzweigung des Audiosignals zu dem optionalen Hoch- und Obertonfilter 4 auf. Das Ausgangssignal des Hoch- und Obertonfilters 4 ist über einen Widerstand auf den nicht-invertierenden Eingang des Operationsverstärkers OP₁₂ der Ausgangs-Summierstufe 12 geschaltet.

Das Ausgangssignal des Steuerfilters 3 ist über einen Widerstand zu einem Knotenpunkt 28 geführt, der auch das Audiosignal über den Nebenzweig C empfängt. Dieser Knoten 28 bildet das Eingangssignal für die modifizierte Bandpaßfilterstufe 6. Die Bandpaßfilterstufe 6 weist einen ersten Operationsverstärker OP₆₁ und einen zweiten Operationsverstärker OP₆₂ auf, die wie in Fig. 2 gezeigt mittels Widerständen und Kondensatoren zu einem aktiven modifizierten Bandpaßfilter verschaltet sind. Das Eingangssignal vom Knoten 28 ist an den nicht-invertierenden Eingang des ersten Operationsverstärkers OP₆₁ geführt, wobei das modifizierte aktive Bandpaßfilter 6 so dimensioniert ist, daß es wie ein frequenzabhängiger Widerstand gegen Masse wirkt, der bei einer sehr niedrigen Frequenz, z.B. 50 Hz, sein Maximum erreicht.

Das Audiosignal, welches das Steuerfilter 3 und das aktive Bandpaßfilter durchlaufen hat, wird an den Steuereingang des modifizierten Universalfilters 7 angelegt. Mit Hilfe des Reglers 26 des Steuerfilters 3 und dem aufsummierten Bandpaßfilter 6 lassen sich gewünschte Baß-Klangfarben am Universalfilter 7 einstellen. Über den Regler 26 in dem Steuerfilter 3 und das aufsummierte Bandpaßfilter 6 läßt sich das Baßsignal derart beeinflussen, daß man ein weitgehend unverändertes Baßsignal, einen sehr perkussiven, harten Baßklang oder einen sehr weichen, runden Baßklang erhält. Dies wird als Einstellung der Baßklangfarben bezeichnet.

Das modifizierte Universalfilter 7 weist eine erste Eingangsstufe mit einem Spannungsteiler 8 auf, der aus zwei Widerständen gebildet ist und mit einem Steuereingang 30 verbunden ist, auf. Der Steuereingang 30 empfängt das Ausgangssignal des modifizierten Bandpaßfilters 6. Der Eingangsstufe mit dem Spannungsteiler ist das Kernstück des modifizierten Universalfilters 7, oder der Universalfilterkern 14, nachgeschaltet, der aus drei Operationsverstärkern OP₇₁, OP₇₂ und OP₇₃ gebildet ist, welche wie in Fig. 2 gezeigt mit Widerständen und Kondensatoren verschaltet sind. Die Verschaltung dieser Operationsverstärker erfolgt anders als bei aus dem Stand der Technik bekannten Universalfiltern, sowie auch die Verschaltung des modifizierten Bandpaßfilters 6 und des Steuerfilters oder aktiven Flächeneinstellers 3 nicht wie im Stand der Technik üblich ist

Die Erfinder haben herausgefunden, daß sich durch die Modifikation der Filterschaltungen, wie sie in den Figuren gezeigt und hier beschrieben ist, besonders vorteilhafte Filtereigenschaften in bezug auf die Klangfarbe und die Frequenzentzerrung ergeben.

In dem Universalfilterkern 14 arbeitet der erste Operationsverstärker OP₇₁ als Tiefpaß, der zweite Operationsverstärker OP₇₂ bildet einen Bandpaß, und der dritte Operationsverstärker OP₇₃ arbeitet als Hochpaß, wobei die Operationsverstärker insgesamt zwei Integratoren bilden.

Gegenüber einem "normalen" Universalfilter ist das Universalfilter gemäß der Erfindung so modifiziert, daß die Eingangsbeschaltung des Tiefpaß, OP₇₁ nicht der eines üblichen Tiefpaßeingangs entspricht und daß noch ein zweiter Eingang des Universalfilters 7 über die zweite Eingangsstufe 9 vorgesehen wird. Auch der Bandpaß, OP₇₂, ist nicht auf übliche Weise gebildet, weil er sein Eingangssignal auf dem invertierenden Eingang erhält.

Das über den Spannungsteiler 8 geführte Summenausgangssignal aus dem Steuerfilter 3 und dem modifizierten Bandpaßfilter 6 wird an den nicht-invertierenden Eingang des ersten Operationsverstärker OP₇₁ angelegt, der als Tiefpaß arbeitet. Zusammengefaßt werden bei der Erfindung zwar die Kernelemente eines Universalfilters, nämlich Tiefpaß, Hochpaß und Bandpaß, übernommen, deren Ansteuerung und Verknüpfung wird jedoch verändert.

Zusätzlich kann durch die Integration von Reglern und/oder zuschaltbaren Induktivitäten, wie bei 32 angedeutet, am invertierenden Eingang des Operationsverstärkers OP₇₁ des Tiefpaß-Integrators eine weitere Einstellung der Klangfilterung vorgesehen werden

Das modifizierte Universalfilter 7 erhält ein zweites Steuersignal über den Nebenzweig D aus dem Widerstandsnetzwerk 2, wobei dieses Signal auf den nicht-invertierenden Eingang eines Operationsverstärker OP₉ der Verstärkerstufe 9 geführt ist. Der Ausgang der Verstärkerstufe 9 ist auf einen Knotenpunkt 15 gerührt der über einen Spannungsteiler an den nicht-invertierenden Eingang des Operationsverstärkers OP₇₃ des Hochpaßfilters gelegt ist. An dem Knoten 15 ist auch ein Regler 10 angeschlossen, mit dem die Bandbreite, welche den Frequenzbereich für die Mitten-Hochton-Absenkung bzw. -Anhebung bestimmt, individuell eingestellt werden kann. Das Ausgangssignal der durch den Operationsverstärker OP₇₂ gebildeten aktiven Bandpaßstufe führt über den Knoten 15 auf einen Regler 11, mit dem das Signal auf den invertierenden Eingang des Operationsverstärkers OP₁₂ der Ausgangs-Summierstufe 12 aufgeschaltet werden kann.

An diesem Punkt können optional weitere Bearbeitungsstufen und -funktionen eingefügt werden, beispielsweise mittels eines Kompressors/Begrenzers, eines Zeitkorrektur-Elementes oder dergleichen.

Durch die genaue Verteilung der verschiedenen Filterausgangssignale und des Bezugssignals auf die invertierenden und nicht-invertierenden Eingängen des Operationsverstärkers OP₁₂ der Ausgangssummierstufe 12 entsteht eine Wechselwirkung von Frequenz und Phase des Audiosignal am Ausgang des Summierers. Diese Wechselwirkung, zusätzlich erweitert durch Regler oder Schalter in den einzelnen Filterstufen bestimmt die gesamte Frequenzentzerrung der erfindungsgemäßen Audio-Filterschaltung.

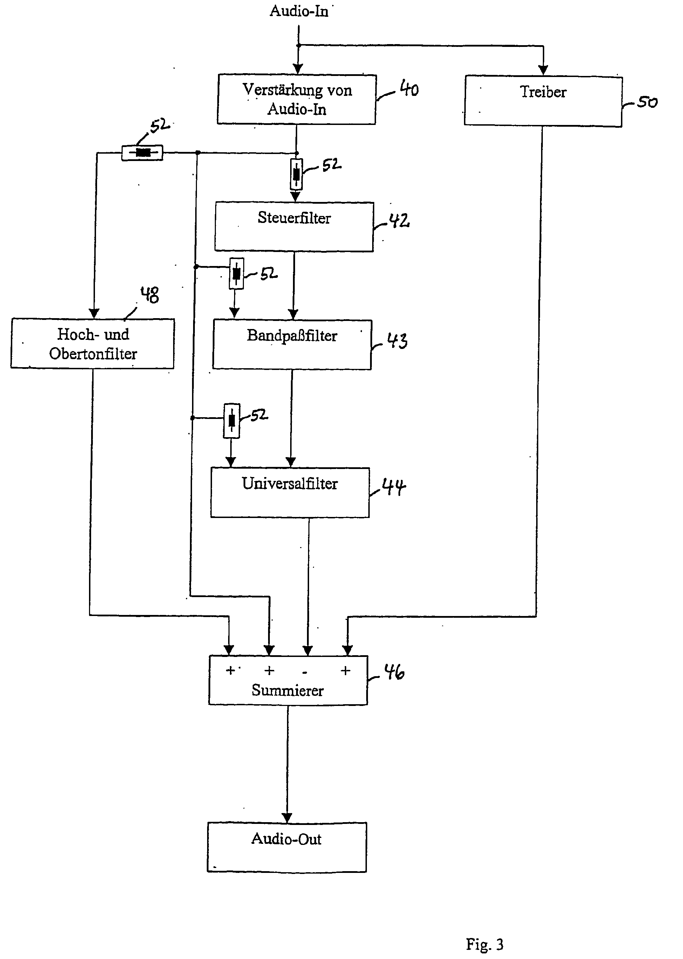

Fig. 3 schließlich zeigt schematisch ein Ablaufdiagramm, das illustriert, wie die erfindungsgemäße Filterschaltung in einem Verfahren bzw. in einem digitalen Algorithmus realisiert werden kann, der als ein Computerprogramm umgesetzt werden kann. Wie in Fig. 3 gezeigt durchläuft das Audiosignal eine Verstärkungsstufe 40, die durch eine Multiplikation mit einem einstellbaren Koeffizient realisiert werden kann. Das verstärkte Audiosignal durchläuft nacheinander eine Steuerfilterfunktion 42, eine Bandpaßfilterfunktion 43 und eine Universalfilterfunktion 44, welche das Signal jeweils so verarbeiten, wie es durch die Schaltungen des Steuerfilters 3, des Bandpaßfilters 6 und des Universalfilters 7 vorgegeben ist. Das Ausgangssignal des Universalfilters 44 wird in eine Summiererfunktion 46 eingegeben. Das verstärkte Audiosignal wird ferner am Ausgang der Verstärkungsfunktion 40 abgezweigt und direkt auch als Steuerparameter in die Bandpaßfilterfunktion 43, die Universalfilterfunktion 44 und die Summiererfunktion 46 eingegeben. Zusätzlich wird das verstärkte Audiosignal am Ausgang der Verstärkerfunktion 40 in eine Hoch- und Obertonfilterfunktion 48 eingegeben, deren Ausgangssignal ebenfalls auf die Summiererfunktion 46 geschaltet wird. Schließlich wird auch das im wesentlichen unveränderte Audiosignal über eine 1: 1-Treiberfunktion 50 auf die Summiererfunktion 46 aufgeschaltet. Die zu den jeweiligen Signalwegen parallel gezeichneten Widerstände deuten an, daß die jeweilige Signale in den Wegen entsprechend der Funktion des Widerstandsnetzwerks 2 gewichtet (52) werden können. Die einzelnen Funktionsblöcke realisieren die Funktionen, welche in Fig. 2 als Schaltungsdiagramme gezeigt sind. Der Fachmann weiß, wie er diese Funktionen in Software realisieren kann.

Das erfindungsgemäße Filterverfahren kann als ein Algorithmus in einem Computerprogramm realisiert werden, welches auf einem Personalcomputer, einem Allzweckrechner oder einem Spezialrechner laufen kann oder das in einem Mikroprozessor zum Einbau in Geräte der Konsumerelectronik, Informationstechnologie oder Telekommunikationstechnik integriert werden kann. Die Filterschaltung kann als analoge Schaltung oder als integrierter Halbleiterschaltkreis realisiert werden, die erfindungsgemäße Filterschaltung ist auch durch eine Kombination aus Hardware, Firmware und/oder Software realisierbar.

Die in der vorstehenden Beschreibung, den Ansprüchen und den Figuren gezeigten Merkmale können sowohl einzeln als auch in beliebiger Kombination für die Verwirklichung der Erfindung in ihren verschiedenen Ausgestaltung von Bedeutung sein.

## Patentansprüche

1. Filterschaltung zur Verarbeitung eines Audiosignals, mit
einem ersten Zweig (20), in dem das Audiosignal im wesentlichen unverändert zu einer Ausgangs-Summierstufe (12) geführt wird, und
einem zweiten Zweig (22), der mehrere in Reihe geschaltete Filterstufen (3, 6, 7) aufweist, wobei das Audiosignal in eine erste Filterstufe (3) der in Reihe geschalteten Filterstufen eingegeben und über die in Reihe geschalteten Filterstufen zu der Ausgangs-Summierstufe (12) geführt wird, und wobei der zweite Zweig mehrere Nebenzweige aufweist, über die das Audiosignal weiteren Filterstufen (6, 7) der in Reihe geschalteten Filterstufen direkt zugeführt wird, und
wobei wenigstens eine der Filterstufen einstellbar ist und das Ausgangssignal der eingestellten Filterstufe die Filterfunktion wenigstens einer nachgeschalteten Filterstufe steuert.

2. Filterschaltung nach Anspruch 1, **dadurch gekennzeichnet, daß** jede der Filterstufen (3, 6, 7) das Audiosignal über die Nebenzweige direkt empfängt.

3. Filterschaltung nach Anspruch 1 oder 2, **dadurch gekennzeichnet, daß** die Nebenzweige Widerstände (2) zur Gewichtung des Audiosignals aufweisen.

4. Filterschaltung nach einem der vorangehenden Ansprüche, **dadurch gekennzeichnet, daß** die Filterstufen ein Steuerfilter (3), ein Bandpaßfilter (6) und ein Universalfilter (7) umfassen, die in dieser Reihenfolge in Reihe geschaltet sind.

5. Filterschaltung nach Anspruch 4, **dadurch gekennzeichnet, daß** das Steuerfilter (3) als aktiver Flächeneinsteller realisiert ist, der in einem ersten, höheren Frequenzbereich eine feste Einstellung von Frequenz und Amplitude aufweist und in einem zweiten, niedrigeren Frequenzbereich eine feste Frequenzeinstellung aufweist und in der Amplitude variabel einstellbar ist.

6. Filterschaltung nach einem der vorangehenden Ansprüche, **dadurch gekennzeichnet, daß** das Universalfilter (7) einen Universalfilterkern (14) aufweist, der einen Tiefpaß (OP₇₁), einen Bandpaß (OP₇₂) und einen Hochpaß (OP₇₃) umfaßt.

7. Filterschaltung nach Anspruch 6, **dadurch gekennzeichnet, daß** der Universalfilterkern drei Operationsverstärker (OP₇₁, OP₇₂, OP₇₃) aufweist, die so angeordnet sind, daß sie zwei Integratoren bilden.

8. Filterschaltung nach Anspruch 6 oder 7, **dadurch gekennzeichnet, daß** das Universalfilter (7) folgende Merkmale aufweist: eine erste Eingangsstufe mit einem Spannungsteiler (8), eine zweite Eingangsstufe mit einem Eingangsverstärker (9), den Universalfilterkern (14), und einen Regler (10), wobei der Ausgang der ersten Eingangsstufe (8) das Eingangssignal des Tiefpasses (OP₇₁) des Universalfilterkerns (14) bildet, das Ausgangssignal der zweiten Eingangsstufe (9) das Eingangssignal des Hochpasses (OP₇₃) des Universalfilterkerns (14) bildet, und der Regler (10) mit einem Knoten (15) verbunden ist, der auch mit dem Eingang des Hochpasses (OP₇₃) des Universalfilterkerns (14) verbunden ist, und wobei der Knoten (15) auch den Ausgang des Universalfilters (7) bildet.

9. Filterschaltung nach einem der vorangehenden Ansprüche, **dadurch gekennzeichnet, daß** dem zweiten Zweig (22) ein regelbarer Verstärker (1) vorgeschaltet ist.

10. Filterschaltung nach einem der vorangehenden Ansprüche, **dadurch gekennzeichnet, daß** der zweite Zweig (22) einen weiteren Nebenzweig aufweist, der ein Hoch- und Obertonfilter (4) enthält, dessen Eingang das Audiosignal empfängt und dessen Ausgang mit der Ausgangs-Summierstufe (12) verbunden ist.

11. Verfahren zur Verarbeitung eines Audiosignals, bei dem das Audiosignal mit einer ersten Filterfunktion verarbeitet wird, um ein erstes verarbeitetes Audiosignal zu erzeugen,
das Audiosignal und das erste verarbeitete Audiosignal mit einer zweiten Filterfunktion verarbeitet werden, um ein zweites verarbeitetes Audiosignal zu erzeugen,
das Audiosignal und das zweite verarbeitete Audiosignal mit einer dritten Filterfunktion verarbeitet werden, um ein drittes verarbeitetes Audiosignal zu erzeugen,
und das dritte verarbeitete Audiosignal und das im wesentlichen unverarbeitete Audiosignal summiert werden, um ein Audio-Ausgangssignal zu erzeugen,
wobei wenigstens eine der Filterfunktion einstellbar ist und das Ausgangssignal der eingestellten Filterfunktion eine nachgeschaltete Filterfunktion steuert.

12. Verfahren nach Anspruch 11, **dadurch gekennzeichnet, daß** das Audiosignal gewichtet wird, bevor es den Filterfunktionen zugeführt wird.

13. Verfahren nach Anspruch 11 oder 12, **dadurch gekennzeichnet, daß** das Audiosignal verstärkt wird, bevor es den Filterfunktionen zugeführt wird.

14. Verfahren nach Anspruch 13, **dadurch gekennzeichnet, daß** das verstärkte Audiosignal mit dem dritten verarbeiteten Audiosignal und dem im wesentlichen unverarbeiteten Audiosignal summiert wird.

15. Verfahren nach Anspruch 14, **dadurch gekennzeichnet, daß** das verstärkte Audiosignal mit einer vierten Filterfunktion verarbeitet wird, um ein viertes verarbeitetes Audiosignal zu erzeugen, das mit dem verstärkten Audiosignal, dem dritten verarbeiteten Audiosignal und dem im wesentlichen unverarbeiteten Audiosignal summiert wird.

16. Verfahren nach Anspruch 15, **dadurch gekennzeichnet, daß** das dritte verarbeitete Audiosignal invertiert wird, bevor es mit dem vierten verarbeiteten Audiosignal, dem verstärkten Audiosignal, und dem im wesentlichen unverarbeiteten Audiosignal summiert wird.

17. Verfahren nach einem der Ansprüche 11-16, **dadurch gekennzeichnet, daß** die erste Filterfunktion ein Steuerfunktion umfaßt, die zweite Filterfunktion ein Bandpaßfilterung umfaßt und die dritte Filterfunktion eine Universalfilterung umfaßt.

18. Verfahren nach Anspruch 17, **dadurch gekennzeichnet, daß** die Steuerfunktion in einem ersten, höheren Frequenzbereich eine feste Einstellung von Frequenz und Amplitude vorsieht und in einem zweiten, niedrigeren Frequenzbereich eine feste Frequenzeinstellung vorsieht und eine variable Einstellung der Amplitude ermöglicht.

19. Verfahren nach Anspruch 17 oder 18, **dadurch gekennzeichnet, daß** die Universalfilterung eine Tiefpaßfilterung, eine Bandpaßfilterung und eine Hochpaßfilterung umfaßt.

20. Verfahren nach Anspruch 19, **dadurch gekennzeichnet, daß** die Universalfilterung eine Integration umfaßt und daß die Frequenzbereiche der Tiefpaßfilterung, Bandpaßfilterung und Hochpaßfilterung einstellbar sind.

21. Verfahren nach einem der Ansprüche 11-20, **dadurch gekennzeichnet, daß** die vierte Filterfunktion eine Hoch- und Obertonfilterung umfaßt.

22. Computerprogramm umfassend einen Programmcode, der das Verfahren nach einem der vorangehenden Ansprüche 11-21 ausführt, wenn das Computerprogramm auf einem Rechner läuft.

23. Datenträger mit einem darauf gespeicherten Computerprogramm gemäß Anspruch 22.

## Claims

1. A filter circuit for processing an audio signal, having
a first path (20), in which the audio signal is routed essentially unchanged to an output summing stage (12), and
a second path (22), which has a plurality of series-connected filter stages (3, 6, 7), where the audio signal is input into a first filter stage (3) from the series-connected filter stages and is routed via the series-connected filter stages to the output summing stage (12), and where the second path has a plurality of subsidiary paths via which the audio signal is supplied directly to further filter stages (6, 7) from the series-connected filter stages, and
where at least one of the filter stages is adjustable and the output of the adjusted filter stage controls the filter function of at least one downstream filter stage.

2. The filter circuit as claimed in claim 1, **characterized in that** each of the filter stages (3, 6, 7) receives the audio signal via the subsidiary paths directly.

3. The filter circuit as claimed in claim 1 or 2, **characterized in that** the subsidiary paths have resistors (2) for weighting the audio signal.

4. The filter circuit as claimed in one of the preceding claims, **characterized in that** the filter stages comprise a control filter (3), a bandpass filter (6) and a modified universal filter (7) which are connected in series in this order.

5. The filter circuit as claimed in claim 4, **characterized in that** the control filter (3) is in the form of an active area adjuster which, in a first, relatively high frequency range, has a fixed adjustment for frequency and amplitude and, in a second, relatively low frequency range, has a fixed frequency adjustment and can be adjusted so as to vary the amplitude.

6. The filter circuit as claimed in one of the preceding claims, **characterized in that** the universal filter (7) has a universal filter core (14) which comprises a low-pass filter (OP₇₁), a bandpass filter (OP₇₂) and a high-pass filter (OP₇₃).

7. The filter circuit as claimed in claim 6, **characterized in that** the universal filter core has three operational amplifiers (OP₇₁, OP₇₂, OP₇₃) arranged such that they form two integrators.

8. The filter circuit as claimed in claim 6 or 7, **characterized in that** the universal filter (7) has the following features: a first input stage having a voltage divider (8), a second input stage having an input amplifier (9), the universal filter (14) and a control (10), where the output of the first input stage (8) forms the input signal for the low-pass filter (OP₇₁) in the universal filter core (14), the output signal from the second input stage (9) forms the input signal for the high-pass filter (OP₇₃) in the universal filter core (14), and the control (10) is connected to a node (15) which is also connected to the input of the high-pass filter (OP₇₃), in the universal filter core (14), and where the node (15) also forms the output of the universal filter (7).

9. The filter circuit as claimed in one of the preceding claims, **characterized in that** the second path (22) has a controllable amplifier (1) connected upstream of it.

10. The filter circuit as claimed in one of the preceding claims, **characterized in that** the second path (22) has a further subsidiary path, which contains a treble and harmonic filter (4) whose input receives the audio signal and whose output is connected to the output summing stage (12).

11. A method for processing an audio signal, in which the audio signal is processed using a first filter function in order to produce a first processed audio signal, the audio signal and the first processed audio signal are processed using a second filter function in order to produce a second processed audio signal, the audio signal and the second processed audio signal are processed using a third filter function in order to produce a third processed audio signal, and the third processed audio signal and the essentially unprocessed audio signal are summed in order to produce an audio output signal, where at least one of the filter functions is adjustable and the output of the adjusted filter function controls a downstream filter function.

12. The method as claimed in claim 11, **characterized in that** the audio signal is weighted before it is supplied to the filter functions.

13. The method as claimed in claim 11 or 12, **characterized in that** the audio signal is amplified before it is supplied to the filter functions.

14. The method as claimed in claim 13, **characterized in that** the amplified audio signal is summed with the third processed audio signal and the essentially unprocessed audio signal.

15. The method as claimed in claim 14, **characterized in that** the amplified audio signal is processed using a fourth filter function in order to produce a fourth processed audio signal, which is summed with the amplified audio signal, the third processed audio signal and the essentially unprocessed audio signal.

16. The method as claimed in claim 15, **characterized in that** the third processed audio signal is inverted before it is summed with the fourth processed audio signal, the amplified audio signal and the essentially unprocessed audio signal.

17. The method as claimed in claims 11-16, **characterized in that** the first filter function comprises a control function, the second filter function comprises bandpass filtering and the third filter function comprises universal filtering.

18. The method as claimed in claim 17, **characterized in that** the control function, in a first, relatively high frequency range, makes provision for fixed adjustment of frequency and amplitude and, in a second, relatively low frequency range, makes provision for fixed frequency adjustment and allows variable adjustment of the amplitude.

19. The method as claimed in claim 17 or 18, **characterized in that** the universal filtering comprises low-pass filtering, bandpass filtering and high-pass filtering.

20. The method as claimed in claim 19, **characterized in that** the universal filtering comprises integration and **in that** the frequency ranges for the low-pass filtering, bandpass filtering and high-pass filtering are adjustable.

21. The method as claimed in one of claim 11-20, **characterized in that** the fourth filter function comprises treble and harmonic filtering.

22. A computer program comprising a program code which executes the method as claimed in one of the preceding claims 11-21 when the computer program is running on a computer.

23. A data storage medium having a computer program as claimed in claim 22 stored thereon.

## Revendications

1. Circuit de filtrage pour le traitement d'un signal audio, avec une première branche (20), dans laquelle le signal audio est amené, sensiblement sans modification, à un étage mélangeur de sortie (12) et une deuxième branche (22), qui comporte plusieurs étages de filtre (3, 6, 7) montés en série, le signal audio étant entré dans un premier étage de filtrage (3) des étages de filtrage montés en série et amené en passant par les étages de filtrage montés en série à l'étage mélangeur de sortie (12), et la deuxième branche comportant plusieurs branches secondaires par lesquelles le signal audio est directement amené à d'autres étages de filtrage (6, 7) des étages de filtrage montés en série, et dans lequel l'un au moins des étages de filtrage est réglable et le signal de sortie de l'étage de filtrage réglé commande la fonction de filtrage d'au moins un étage de filtre d'aval.

2. Circuit de filtrage selon la revendication 1, **caractérisé en ce que** chacun des étages de filtrage (3, 6, 7) reçoit directement le signal audio via les branches secondaires.

3. Circuit de filtrage selon la revendication 1 ou 2, **caractérisé en ce que** les branches secondaires comportent des résistances (2) pour la pondération du signal audio.

4. Circuit de filtrage selon l'une des revendications précédentes, **caractérisé en ce que** les étages de filtrage comprennent un filtre de commande (3), un filtre passe-bande (6) et un filtre universel (7) qui sont montés en série dans cet ordre.

5. Circuit de filtrage selon la revendication 4, **caractérisé en ce que** le filtre de commande (3) est réalisé comme un régulateur d'aire actif, qui présente dans une première plage de fréquences haute un réglage fixe de la fréquence et de l'amplitude et dans une seconde plage de fréquences plus basse un réglage fixe de la fréquence et un réglage variable de l'amplitude.

6. Circuit de filtrage selon l'une des revendications précédentes, **caractérisé en ce que** le filtre universel (7) comporte un élément central de filtre universel (14) comprenant un passe-bas (OP₇₁), un passe-bande (OP₇₂) et un passe-haut (OP₇₃).

7. Circuit de filtrage selon la revendication 6, **caractérisé en ce que** l'élément central de filtre universel comporte trois amplificateurs opérationnels (OP₇₁ OP₇₂, OP₇₃) qui sont disposés de telle manière qu'ils forment deux intégrateurs.

8. Circuit de filtrage selon la revendication 6 ou 7, **caractérisé en ce que** le filtre universel (7) présente les caractéristiques suivantes : un premier étage d'entrée avec un diviseur de tension (8), un deuxième étage d'entrée avec un amplificateur d'entrée (9), l'élément central de filtre universel (14), et un régulateur (10), la sortie du premier étage d'entrée (8) constituant le signal d'entrée du passe-bas (OP₇₁) de l'élément central de filtre universel (14), le signal de sortie du deuxième étage d'entrée (9) formant le signal d'entrée du passe-haut (OP₇₃) de l'élément central de filtre universel (14), et le régulateur (10) étant connecté à un noeud (15) qui est également connecté à l'entrée du passe-haut (OP₇₃) de l'élément central de filtre universel (14), tandis que le noeud (15) forme aussi la sortie du filtre universel (7).

9. Circuit de filtrage selon l'une des revendications précédentes, **caractérisé en ce qu'**un amplificateur réglable (1) est monté en amont de la deuxième branche (22).

10. Circuit de filtrage selon l'une des revendications précédentes, **caractérisé en ce que** la deuxième branche (22) possède une autre branche secondaire contenant un filtre à aigus et harmoniques (4) dont l'entrée reçoit le signal audio et dont la sortie est connectée à l'étage mélangeur de sortie (12).

11. Procédé pour le traitement d'un signal audio, dans lequel le signal audio est traité avec une première fonction de filtrage pour produire un premier signal audio traité,
le signal audio et le premier signal audio traité sont traités par une deuxième fonction de filtrage pour produire un deuxième signal audio traité,
le signal audio et le deuxième signal audio traité sont traités avec une troisième fonction de filtrage pour produire un troisième signal audio traité,
et le troisième signal audio traité et le signal audio sensiblement non traité sont additionnés pour produire un signal audio de sortie,
l'une au moins des fonctions de filtrage étant réglable et le signal de sortie de la fonction de filtrage réglée commandant une fonction de filtrage d'aval.

12. Procédé selon la revendication 11, **caractérisé en ce que** le signal audio est pondéré avant d'être amené aux fonctions de filtrage.

13. Procédé selon la revendication 11 ou 12, **caractérisé en ce que** le signal audio est amplifié avant d'être amené aux fonctions de filtrage.

14. Procédé selon la revendication 13, **caractérisé en ce que** le signal audio amplifié est additionné avec le troisième signal audio traité et le signal audio sensiblement non traité.

15. Procédé selon la revendication 14, **caractérisé en ce que** le signal audio amplifié est traité avec une quatrième fonction de filtrage pour produire un quatrième signal audio traité qui est additionné au signal audio amplifié, au troisième signal audio traité et au signal audio sensiblement non traité.

16. Procédé selon la revendication 15, **caractérisé en ce que** le troisième signal audio traité est inversé avant d'être additionné au quatrième signal audio traité, au signal audio amplifié et au signal audio sensiblement non traité.

17. Procédé selon l'une des revendications 11-16, **caractérisé en ce que** la première fonction de filtrage comprend une fonction de commande, la deuxième fonction de filtrage un filtrage passe-bande et la troisième fonction de filtrage un filtrage universel.

18. Procédé selon la revendication 17, **caractérisé en ce que** la fonction de commande prévoit dans une première plage de fréquences haute un réglage fixe de la fréquence et de l'amplitude et dans une deuxième plage de fréquences plus basse un réglage fixe de la fréquence et réglage variable de l'amplitude.

19. Procédé selon la revendication 17 ou 18, **caractérisé en ce que** le filtrage universel comprend un filtrage passe-bas, un filtrage passe-bande et un filtrage passe-haut.

20. Procédé selon la revendication 19, **caractérisé en ce que** le filtrage universel comprend une intégration et **en ce que** les plages de fréquence du filtrage passe-bas, du filtrage passe-bande et du filtrage passe-haut sont réglables.

21. Procédé selon l'une des revendications 11 à 20, **caractérisé en ce que** la quatrième fonction de filtrage comprend un filtrage des aigus et des harmoniques.

22. Programme d'ordinateur comprenant un code de programme qui exécute le procédé selon l'une quelconque des revendications 11 à 21 lorsque le programme d'ordinateur s'exécute sur un ordinateur.

23. Support de données sur lequel est mémorisé un programme d'ordinateur selon la revendication 22.
